# EUROPEAN PATENT APPLICATION

(11) **EP 4 446 057 A1**
(43) Date of publication of application: **16.10.2024**
(21) Application number: 24170073.1
(22) Date of filing: 12.04.2024
(51) Int. Cl.: B24B 37/24

(54) **POLISHING PAD WITH ADJUSTED CONTENT OF CHLORINE AND PROCESS FOR PREPARING SEMICONDUCTOR DEVICE USING THE SAME**

(30) Priority: 14.04.2023 KR 20230049366
(71) Applicant: SK enpulse Co., Ltd., Pyeongtaek-si, Gyeonggi-do 17784 (KR)
(72) Inventor: YUN, Jong Wook, 17784 Gyeonggi-do (KR); SHIN, Yujin, 17784 Gyeonggi-do (KR); MOON, Suyoung, 17784 Gyeonggi-do (KR); MIN, Eun Gi, 17784 Gyeonggi-do (KR); HONG, Tae Il, 17784 Gyeonggi-do (KR); SEO, Jangwon, 17784 Gyeonggi-do (KR); JI, Min Gyeong, 17784 Gyeonggi-do (KR)
(74) Representative: Dehns

(57) **Abstract**

The polishing pad according to an embodiment has a chlorine content adjusted to a certain range, whereby it is possible to reduce the size of debris while maintaining excellent physical properties and performance of the polishing pad, thereby minimizing the occurrence of defects and scratches during a CMP process.

## Description

### Technical Field

Embodiments relate to a polishing pad capable of reducing the occurrence of defects and scratches during a chemical mechanical polishing (CMP) process by adjusting the content of chlorine and to a process for preparing a semiconductor device using the same.

### Background Art

The chemical mechanical planarization (CMP) in a process for preparing semiconductors refers to a step in which a semiconductor substrate such as a wafer is fixed to a head and in contact with the surface of a polishing pad mounted on a platen, and the surface of the semiconductor substrate is then chemically treated by supplying a slurry while the platen and the head are relatively moved, to thereby mechanically planarize the irregularities on the surface of the semiconductor substrate.

A polishing pad is an essential member that plays an important role in such a CMP process. In general, a polishing pad is composed of a polyurethane resin and has grooves on its surface for a large flow of a slurry and pores for supporting a fine flow thereof.

For the preparation of such a polishing pad, a diisocyanate and a polyol are reacted to obtain a prepolymer, which is mixed with a curing agent and a foaming agent and then cured to obtain a polyurethane foam sheet. Thereafter, the upper and lower surfaces of the polyurethane foam sheet are sliced to the desired thickness to obtain an upper pad, grooves are formed in a specific shape using a tip or the like on the surface of the upper pad, and it is then bonded with a polyurethane lower pad to prepare a polishing pad.

The CMP process may be carried out several times in the process of preparing a semiconductor device. A semiconductor device comprises a plurality of layers, in which each layer comprises a complex and fine circuit pattern. In addition, in recent years, the sizes of individual chips of a semiconductor device have been reduced, and the pattern of each layer is evolving to be more complex and finer. Accordingly, in the process of preparing a semiconductor device, the purpose of the CMP process has been expanded not only for the purpose of planarizing the circuit wiring, but also for the separation of the circuit wiring and the application of improvement of the wiring surface, and the like. As a result, more sophisticated and reliable CMP performance is required.

During the CMP process using such a polishing pad, debris is formed by friction between the polishing surface and the semiconductor substrate or when the polishing surface is cut by a diamond disk for conditioning.

### Prior Art Document

(Patent Document 1) Korean Laid-open Patent Publication No. 2016-0027075

### Disclosure of Invention

### Technical Problem

During a CMP process using a polishing pad, debris is formed by friction between the polishing surface and the semiconductor substrate or when the polishing surface is cut by a diamond disk for conditioning. Such debris causes defects and scratches on the polished surface during the CMP process.

Accordingly, as a result of research conducted by the present inventors, it has been discovered that the content of chlorine (Cl) in a polishing pad has an impact on the size and surface characteristics of debris that is formed during the conditioning of the polishing pad; and that as the chlorine content is adjusted to a certain range, it is possible to reduce the size of debris while maintaining excellent physical properties and performance of the polishing pad, thereby minimizing the occurrence of defects and scratches during a CMP process.

Therefore, an object of the embodiments relates to a polishing pad with a content of chlorine adjusted to a certain range and to a process for preparing a semiconductor device using the same.

### Solution to Problem

According to an embodiment, there is provided a polishing pad that comprises a polishing layer and a support layer, wherein the polishing layer comprises a urethane-based prepolymer, a foaming agent, and a curing agent, and the polishing layer has a content of chlorine (Cl) of 10,000 ppm or less when analyzed according to the IEC 62321-3-2 standard.

According to another embodiment, there is provided a process for preparing a polishing pad that comprises preparing a composition for a polishing pad comprising a urethane-based prepolymer, a foaming agent, and a curing agent; injecting the composition for a polishing pad into a mold and curing it to prepare a polishing layer; and laminating the polishing layer with a support layer, wherein the foaming agent comprises a solid phase foaming agent, the solid phase foaming agent comprises at least one selected from the group consisting of an acrylonitrile-based copolymer, a methyl methacrylate-based copolymer, a methacrylonitrile-based copolymer, and an acrylic-based copolymer, and the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

According to still another embodiment, there is provided a process for preparing a semiconductor device that comprises polishing the surface of a semiconductor substrate using the polishing pad.

### Advantageous Effects of Invention

As the polishing pad according to the embodiment has a content of chlorine adjusted to a certain range, it is possible to reduce the size of debris while maintaining excellent physical properties and performance of the polishing pad, thereby minimizing the occurrence of defects and scratches during a CMP process.

In addition, the polishing pad according to the embodiment does not use, or minimize, chlorine-based components such as bis(4-amino-3-chlorophenyl)methane (MOCA) and vinylidene chloride (VDC), which are commonly used as raw materials, so that there is no harmful problem to the human body and the environment.

### Brief Description of Drawings

Fig. 1 illustrates a process for preparing a semiconductor device using a polishing pad according to an embodiment.
Fig. 2 shows the occurrence of a defect caused by debris during the process for preparing a semiconductor device.
Fig. 3 shows an apparatus for measuring the chlorine content of a polishing pad according to an embodiment.
Fig. 4 shows a solid phase foaming agent used in a polishing pad according to an embodiment.

### <Reference Numeral of the Drawings>

100: polishing pad, 110: polishing layer (sample), 130: solid phase foaming agent, 131: shell, 132: expansion-inducing component, 150: debris, 200: platen, 300: conditioner, 400: polishing slurry, 510: polishing head, 520: carrier, 600: semiconductor substrate (wafer), 650: defect, 700: apparatus for measuring the chlorine content of a polishing pad, 710: injection gas (Ar/O₂), 730: combustion tube, 750: electric furnace, 770: adsorption tube, 790: valve for transferring to ion chromatography.

### Best Mode for Carrying out the Invention

Hereinafter, various embodiments and examples will be described in detail with reference to the drawings.

Further, in the following description of the embodiments, a detailed description of known functions and configurations incorporated herein will be omitted when it is determined that the description may make the subject matter of the embodiments rather unclear. In addition, for the sake of description, the sizes of individual elements in the appended drawings may be exaggeratedly depicted or omitted, and they may differ from the actual sizes.

In the present specification, in the case where an element is mentioned to be formed, connected, or combined on or under another element, it means all of the cases where one element is directly, or indirectly through another element, formed, connected, or combined with another element. In addition, it should be understood that the criterion for the terms on and under of each component may vary depending on the direction in which the object is observed.

In this specification, terms referring to the respective components are used to distinguish them from each other and are not intended to limit the scope of the embodiment. In addition, in the present specification, a singular expression is interpreted to cover a plural number as well unless otherwise specified in the context.

Throughout the present specification, the terms first, second, and the like are used to describe various components. But the components should not be limited by the terms. The terms are used for the purpose of distinguishing one element from another.

In the present specification, the term "comprising" is intended to specify a particular characteristic, region, step, process, element, and/or component. It does not exclude the presence or addition of any other characteristic, region, step, process, element and/or component, unless specifically stated to the contrary.

As is well known, the molecular weight of the compound or the molecular weight of the polymer described in the present specification, such as number average molecular weight or weight average molecular weight, is a relative mass based on carbon-12 and is not stated in units. If necessary, however, it may be understood as having the same molar mass (g/mole).

In the numerical range that limits the size, physical properties, and the like of components described in the present specification, when a numerical range limited with the upper limit only and a numerical range limited with the lower limit only are separately exemplified, it should be understood that a numerical range combining these upper and lower limits is also encompassed in the exemplary scope of the invention.

### Polishing pad

The polishing pad according to an embodiment comprises a polishing layer and a support layer. In addition, an adhesive layer may be interposed between the polishing layer and the support layer.

In the polishing pad according to an embodiment, the polishing layer has a content of chlorine (Cl) of 10,000 ppm or less when analyzed according to the IEC 62321-3-2 standard.

Specifically, the chlorine content may be obtained by measuring the content of chlorine in a sample by IEC 62321-3-2, which is an international standard for measuring specific substances in a polymer by combustion-ion chromatography (C-IC). In such an event, the sample to be measured for the chlorine content may be a circular sample taken in a size of 3 cm in diameter and 0.3 cm in height from the polishing layer of the polishing pad.

The IEC 62321-3-2 standard is a test method for screening halogen components developed in response to regulations for halogen use. The test method has excellent precision/accuracy and reproducibility as compared with conventional halogen analysis methods (e.g., oxygen bomb-IC and oxygen flask-IC) and is automated; thus, the reliability of the test results is excellent.

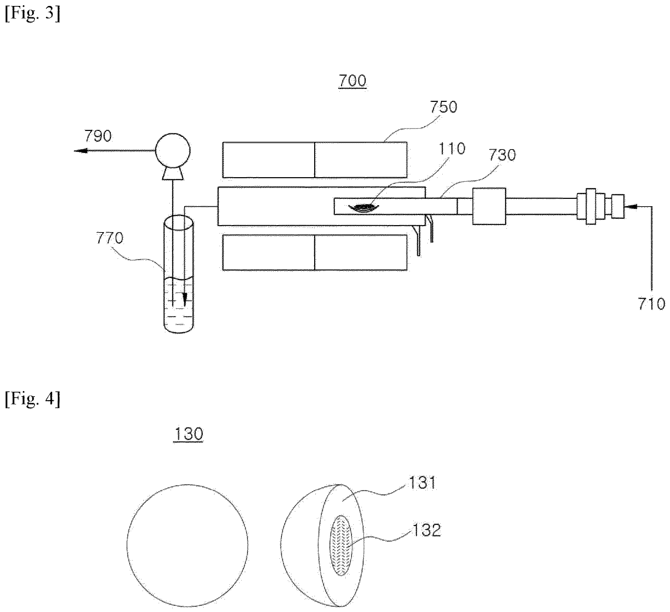

Fig. 3 illustrates a method for measuring the chlorine content of a polishing pad according to an embodiment. Referring to Fig. 3, a sample (110) containing an organic chlorine (C-Cl) component is injected into a combustion tube (730) and combusted by an electric furnace (750). The resultant is transferred to an adsorption tube (770) to measure the amount of chlorine ions (Cl⁻) by ion chromatography.

In the polishing pad according to an embodiment, the content of chlorine in the polishing layer may be 10,000 ppm or less, for example, 5,000 ppm or less, 1,000 ppm or less, 500 ppm or less, 200 ppm or less, 100 ppm or less, 80 ppm or less, or 50 ppm or less. As the content of chlorine is adjusted to the above range, it is possible to reduce the size of debris while maintaining excellent physical properties and performance of the polishing pad, thereby minimizing the occurrence of defects and scratches during a CMP process.

In addition, the lower limit of the content range of chlorine in the polishing layer according to an embodiment may be, for example, 0 ppm or more, greater than 0 ppm, 1 ppm or more, 5 ppm or more, 10 ppm or more, 20 ppm or more, 50 ppm or more, or 100 ppm or more. Within the above preferred range, the surface area and adsorption force can be adjusted as the debris agglomerates into an appropriate size to facilitate adsorption and desorption in the wafer and pad, and the electrical attraction/repulsion force can be adjusted to make the polishing performance more appropriate.

As a specific example, the polishing layer has a content of chlorine (Cl) of 10 ppm to 1,000 ppm when analyzed according to the IEC 62321-3-2 standard. As another specific example, the polishing layer has a content of chlorine (Cl) of 10 ppm to 100 ppm, 20 ppm to 80 ppm, or 20 ppm to 50 ppm, when analyzed according to the IEC 62321-3-2 standard. As another specific example, the polishing layer has a content of chlorine (Cl) of 50 ppm to 10,000 ppm or 100 ppm to 10,000 ppm, when analyzed according to the IEC 62321-3-2 standard.

As the polishing pad according to an embodiment has a content of chlorine adjusted to a certain range as described above, it is possible to reduce the size of debris, thereby minimizing the occurrence of defects and scratches during a CMP process.

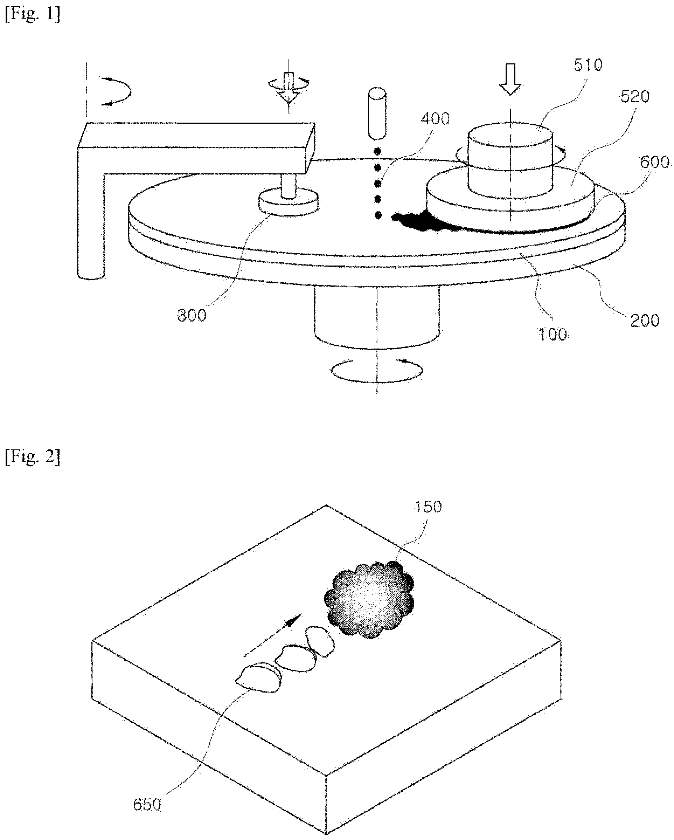

Fig. 2 shows the occurrence of a defect caused by debris during the process for preparing a semiconductor device. Referring to Fig. 2, defects (650) or scratches are formed on the surface of a semiconductor device by debris (150) originating from the polishing layer. According to the embodiment, the size of the debris originating from the polishing layer can be adjusted to a certain range, thereby minimizing the occurrence of defects or scratches.

For example, the polishing pad according to an embodiment may have a particle size of debris of 30 µm or less, 25 µm or less, 20 µm or less, 19 µm or less, 18 µm or less, or 17 µm or less, and 5 µm or more, 10 µm or more, or 15 µm or more.

Specifically, the debris may be formed during conditioning while supplying 300 cc/minute of deionized water under the conditions of a platen speed of 93 rpm, a conditioner load of 9 lbs., a conditioner speed of 64 rpm, and a sweep of 19 times/minute. The particle size of the debris may be an average particle size, i.e., a D50 particle size. The particle size of the collected debris may be measured using a particle size analyzer (e.g. Mastersize 3000, Malvern) and a medium-capacity automatic disperser (e.g. Hydro MV, Malvern).

As a specific example, when the polishing pad is conditioned while deionized water is supplied at 300 cc/minute under the conditions of a platen speed of 93 rpm, a conditioner load of 9 lbs., a conditioner speed of 64 rpm, and a sweep of 19 times/minute, the D50 particle size of the polishing pad debris formed may be 30 µm or less.

As another specific example, when the polishing pad is conditioned while deionized water is supplied at 300 cc/minute under the conditions of a platen speed of 93 rpm, a conditioner load of 9 lbs., a conditioner speed of 64 rpm, and a sweep of 19 times/minute, the D50 particle size of the polishing pad debris formed may be 10 µm to 30 µm, 10 µm to 25 µm, or 10 µm to 18 µm.

In addition, the polishing pad according to an embodiment may have a zeta potential value of the debris to be measured within a certain numerical range.

For example, the zeta potential value of an aqueous solution of a pH of 5.5 containing the debris obtained by conditioning the polishing layer at a concentration of 0.01% by weight may be -20 mV or more, -10 mV or more, -5 mV or more, 0 mV or more, 5 mV or more, 7 mV or more, or 10 mV or more, and 40 mV or less, 30 mV or less, 20 mV or less, 15 mV or less, 10 mV or less, or 8 mV or less.

Specifically, the zeta potential value of the aqueous solution of the debris may be a positive value (+).

As a specific example, the zeta potential value of an aqueous solution of a pH of 5.5 containing the debris obtained by conditioning the polishing layer at a concentration of 0.01% by weight may be -10 mV to 30 mV. As another specific example, the zeta potential value of an aqueous solution of a pH of 5.5 containing the debris obtained by conditioning the polishing layer at a concentration of 0.01% by weight may be 7 mV to 15 mV. As another specific example, the zeta potential value of an aqueous solution of a pH of 5.5 containing the debris obtained by conditioning the polishing layer at a concentration of 0.01% by weight may be -10 mV to 8 mV. The zeta potential may be measured using a zetasizer (e.g. Nano-ZS90, Malvern).

Within the above preferred ranges, the zeta potential of debris is similar to the zeta potential of polishing particles (e.g., ceria particles) in a CMP polishing composition (slurry); thus, the occurrence of defects can be further reduced. Specifically, zeta potential is a quantitative representation of the size of repulsion and attraction between particles caused by positive and negative ions of the particles in a suspension. If the zeta potential of debris and that of polishing particles are similar, the repulsion between the particles increases, which prevents agglomeration thereof; thus, the occurrence of defects and scratches can be reduced by reducing the particle size in the composition.

In addition, although the polishing pad according to an embodiment has a content of chlorine adjusted to a certain range, it is possible to maintain excellent physical properties and performance of the polishing pad.

For example, when the silicon oxide layer of a silicon wafer is polished with a ceria slurry using the polishing pad, the polishing rate (removal rate) may be 2,000 Å/minute or more, 2,200 Å/minute or more, 2,300 Å/minute or more, or 2,400 Å/minute or more, and 3,000 Å/minute or less, 2,800 Å/minute or less, 2,600 Å/minute or less, or 2,500 Å/minute or less.

As a specific example, when the silicon oxide layer of a silicon wafer is polished with a ceria slurry using the polishing pad, the polishing rate according to the following Equation 1 may be 2,200 Å/minute to 2,600 Å/minute. Polishing rate (Å/minute) = polished thickness of a silicon wafer (Å )/ polishing time (minute)

Specifically, the polishing rate may be a polishing rate for a silicon wafer having a diameter of 300 mm on which silicon oxide has been deposited. In addition, the polishing rate may be measured under a polishing load of 4.0 psi while the polishing pad is rotated at a speed of 150 rpm, a calcined ceria slurry is supplied onto the polishing pad at a rate of 250 ml/minute, and the platen is rotated at a speed of 150 rpm for 60 seconds. The temperature condition when the polishing rate is measured is not particularly limited, but it may be, for example, a room temperature condition.

In addition, the pad cut rate of the polishing layer may be 30 µm/hr to 60 µm/hr, 30 µm/hr to 50 µm/hr, 40 µm/hr to 60 µm/hr, or 40 µm/hr to 50 µm/hr.

The thickness of the polishing pad may be 0.8 mm to 5.0 mm, 1.0 mm to 4.0 mm, 1.0 mm to 3.0 mm, 1.5 mm to 2.5 mm, 1.7 mm to 2.3 mm, or 2.0 mm to 2.1 mm. Within the above range, the basic physical properties as a polishing pad can be sufficiently exhibited while the size variation of pores between the upper and lower portions is minimized.

### Polishing layer

The polishing layer provides a polishing surface that is in contact with a semiconductor substrate in a CMP process and constitutes a top pad in the polishing pad.

The polishing layer comprises a urethane-based prepolymer, a foaming agent, and a curing agent.

Specifically, the polishing layer comprises a polyurethane-based resin, which is a reaction product of a urethane-based prepolymer, a foaming agent, and a curing agent, i.e., a cured product of a composition in which the components are mixed. More specifically, it comprises a porous polyurethane-based resin. In addition, the polishing layer may comprise a plurality of pores formed from the foaming agent.

The polishing layer may have a thickness of, for example, 0.8 mm or more, 1 mm or more, 1.2 mm or more, or 1.5 mm or more, and 5 mm or less, 3 mm or less, 2.5 mm or less, or 2 mm or less. As a specific example, the thickness of the polishing layer may be 0.8 mm to 5 mm or 1.5 mm to 3 mm.

The polishing layer may have a specific gravity of, for example, 0.6 g/cm³ or more, 0.7 g/cm³ or more, or 0.75 g/cm³ or more, and 0.9 g/cm³ or less, 0.85 g/cm³ or less, or 0.8 g/cm³ or less. As a specific example, the specific gravity of the polishing layer may be 0.6 g/cm³ to 0.9 g/cm³ or 0.7 g/cm³ to 0.9 g/cm³. The specific gravity may be measured using a gravimeter.

The polishing layer may have a hardness of, for example, 30 Shore D or more, 40 Shore D or more, or 50 Shore D or more, and 80 Shore D or less, 70 Shore D or less, 65 Shore D or less, or 60 Shore D or less. As a specific example, the hardness of the polishing layer may be 30 Shore D to 80 Shore D or 50 Shore D to 65 Shore D. The hardness may be measured using a hardness tester.

The polishing layer may have a tensile strength of, for example, 5 N/mm² or more, 10 N/mm² or more, or 15 N/mm² or more, and 30 N/mm² or less, 25 N/mm² or less, or 20 N/mm² or less. As a specific example, the tensile strength of the polishing layer may be 5 N/mm² to 30 N/mm² or 15 N/mm² to 25 N/mm². The tensile strength may be measured using a universal testing machine (UTM).

The polishing layer may have an elongation of, for example, 50% or more, 70% or more, 90% or more, 106% or more, or 120% or more, and 300% or less, 250% or less, 200% or less, or 150% or less. As a specific example, the elongation of the polishing layer may be 50% to 300% or 90% to 130%. The elongation may be an elongation at break. The elongation may be measured using a universal testing machine (UTM).

As a specific example, the polishing layer may have a hardness of 50 Shore D to 65 Shore D, a tensile strength of 15 N/mm² to 25 N/mm², and an elongation of 90% to 130%.

The pores are present as dispersed in the polishing layer.

The average diameter of the pores may be, for example, 10 µm to 60 µm, 10 µm to 50 µm, 20 µm to 50 µm, 20 µm to 40 µm, 10 µm to 30 µm, 20 µm to 25 µm, or 30 µm to 50 µm.

In addition, the total area of the pores may be 30% to 60%, 35% to 50%, or 35% to 43%, based on the total area of the polishing layer. In addition, the total volume of the pores may be 30 to 70%, or 40 to 60%, based on the total volume of the polishing layer.

The polishing layer may have grooves on its surface for mechanical polishing. The grooves may have a depth, a width, and a spacing as desired for mechanical polishing, which is not particularly limited.

### Urethane-based prepolymer

The polishing pad according to an embodiment comprises a urethane-based prepolymer.

A prepolymer generally refers to a polymer having a relatively low molecular weight wherein the degree of polymerization is adjusted to an intermediate level so as to conveniently mold a molded article in the process of producing a cured product. A prepolymer may be molded to a final cured product by itself or after a reaction with another polymerizable compound.

In an embodiment, the urethane-based prepolymer may be prepared by reacting an isocyanate compound with a polyol.

The isocyanate compound used in the preparation of the urethane-based prepolymer may be one selected from the group consisting of an aromatic diisocyanate, an aliphatic diisocyanate, an alicyclic diisocyanate, or combinations thereof.

The isocyanate compound may comprise, for example, one selected from the group consisting of toluene 2,4-diisocyanate (2,4-TDI), toluene 2,6-diisocyanate (2,6-TDI), naphthalene 1,5-diisocyanate, para-phenylene diisocyanate, tolidine diisocyanate, 4,4'-diphenylmethane diisocyanate, hexamethylene diisocyanate, dicyclohexylmethane diisocyanate, isophorone diisocyanate, and combinations thereof.

The polyol is a compound comprising at least two or more hydroxyl groups (-OH) per molecule. For example, it may comprise one selected from the group consisting of a polyether polyol, a polyester polyol, a polycarbonate polyol, a polycaprolactone polyol, and combinations thereof.

The polyol may comprise, for example, one selected from the group consisting of polytetramethylene ether glycol, polypropylene ether glycol, ethylene glycol, 1,2-propylene glycol, 1,3-propylene glycol, 1,2-butanediol, 1,3-butanediol, 2-methyl-1,3-propanediol, 1,4-butanediol, neopentyl glycol, 1,5-pentanediol, 3-methyl-1,5-pentanediol, 1,6-hexanediol, diethylene glycol, dipropylene glycol, tripropylene glycol, and combinations thereof.

The polyol may have a weight average molecular weight (Mw) of 100 to 3,000. The polyol may have a weight average molecular weight (Mw) of, for example, 100 to 3,000, for example, 100 to 2,000, for example, 100 to 1,800.

In an embodiment, the polyol may comprise a low molecular weight polyol having a weight average molecular weight (Mw) of 100 to 300 and a high molecular weight polyol having a weight average molecular weight (Mw) of 300 to 1,800.

The urethane-based prepolymer may have a weight average molecular weight (Mw) of 500 to 3,000. The urethane-based prepolymer may have a weight average molecular weight (Mw) of, for example, 1,000 to 2,000 or, for example, 1,000 to 1,500.

In an embodiment, the isocyanate compound for the preparation of the urethane-based prepolymer may comprise an aromatic diisocyanate compound, and the aromatic diisocyanate compound, for example, may comprise 2,4-toluene diisocyanate (2,4-TDI) and 2,6-toluene diisocyanate (2,6-TDI). The polyol compound for the preparation of the urethane-based prepolymer may comprise polytetramethylene ether glycol (PTMEG) and diethylene glycol (DEG).

In another embodiment, the isocyanate compound for the preparation of the urethane-based prepolymer may comprise an aromatic diisocyanate compound and a cycloaliphatic diisocyanate compound. For example, the aromatic diisocyanate compound comprises 2,4-toluene diisocyanate (2,4-TDI) and 2,6-toluene diisocyanate (2,6-TDI), and the cycloaliphatic diisocyanate compound comprises dicyclohexylmethane diisocyanate (H12MDI). The polyol compound for the preparation of the urethane-based prepolymer may comprise polytetramethylene ether glycol (PTMEG) and diethylene glycol (DEG).

The urethane-based prepolymer may have an isocyanate end group content (NCO%) of 5% by weight or more, 8% by weight or more, or 10% by weight or more, and 13% by weight or less, 12% by weight or less, or 11% by weight or less. As a specific example, the urethane-based prepolymer may have an isocyanate end group content (NCO%) of 10% by weight to 11% by weight.

The isocyanate end group content (NCO%) of the urethane-based prepolymer may be designed by comprehensively adjusting the type and content of the isocyanate compound and the polyol compound for the preparation of the urethane-based prepolymer, the process conditions such as temperature, pressure, and time in the process for preparing the urethane-based prepolymer, and the type and content of the additives used in the preparation of the urethane-based prepolymer.

If the isocyanate end group content (NCO%) of the urethane-based prepolymer satisfies the above range, the reaction rate, reaction time, and final curing structure in the subsequent reaction between the urethane-based prepolymer and a curing agent can be adjusted in a way favorable to the polishing performance from the viewpoint of the use and purpose of a final polishing pad.

In an embodiment, the urethane-based prepolymer may have an isocyanate end group content (NCO%) of 8% by weight to 10% by weight, for example, 8% by weight to 9.4% by weight. If the NCO% of the urethane-based prepolymer is less than the above range, it may be implemented such that the desired polishing performance in terms of polishing rate and flatness is not achieved, and there may be a problem in that the lifespan of the polishing pad is reduced due to an excessive increase in the pad cut rate. On the other hand, if the NCO% exceeds the above range, surface defects such as scratches and chatter marks on the semiconductor substrate may increase.

### Foaming agent

The foaming agent is a component for forming a pore structure in the polishing layer. It may comprise one selected from the group consisting of a solid phase foaming agent, a gas phase foaming agent, a liquid phase foaming agent, and combinations thereof.

According to an embodiment, the foaming agent may be a non-chlorine-based foaming agent that does not contain a chlorine component. In particular, it may not contain, or minimize, the use of a chlorine-based foaming agent component commonly used in the preparation of polishing pads, such as vinylidene chloride (VDC). For example, the content of the non-chlorine-based foaming agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the foaming agent. In addition, the content of the chlorine-based foaming agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the foaming agent.

The foaming agent may be at least one selected from a solid phase foaming agent comprising particles having a hollow structure, a liquid phase foaming agent using a volatile liquid, and an inert gas.

As an example, the solid phase foaming agent may comprise particles having a hollow structure that have been expanded by heat and adjusted in size. Such a solid phase foaming agent has the advantage of controlling the size of pores to be uniform as it is employed in the raw material in an already expanded form and has a uniform particle size.

In addition, the solid phase foaming agent may comprise expandable particles. The expandable particles are particles having a characteristic that can be expanded by heat or pressure. Their size in the final polishing layer may be determined by heat or pressure applied in the process of preparing the polishing layer. The expandable particles are employed in the raw material in a particle state that has not been already expanded. Their final size is determined when expanded by heat or pressure applied during the process of preparing the polishing layer.

The solid phase foaming agent may have an average particle size of 5 µm to 100 µm, specifically, 5 µm to 50 µm or 20 µm to 50 µm. The average particle size of the solid phase foaming agent may refer to the average particle size of expanded particles themselves when the solid phase foaming agent is particles employed in the raw material in an expanded state as described below. It may refer to the average particle diameter of particles after they are expanded by heat or pressure in the preparation process when the solid phase foaming agent is particles employed in the raw material in an unexpanded state as described below.

Fig. 4 shows a solid phase foaming agent as an expandable particle type used in a polishing pad according to an embodiment. Referring to Fig. 4, the solid phase foaming agent (130) as an expandable particle type may comprise a shell (131) of a resin; and an expansion-inducing component (132) encapsulated inside the shell (131). These expandable particles may be formed into a hollow structure by the vaporization of the encapsulated expansion-inducing component by heat during the preparation process.

For example, the shell may comprise a thermoplastic resin. The thermoplastic resin may be at least one selected from the group consisting of an acrylonitrile-based copolymer, a methacrylonitrile-based copolymer, and an acrylic copolymer.

The thickness of the shell may be, for example, 0.1 µm or more, 0.5 µm or more, 1 µm or more, 2 µm or more, or 3 µm or more, and 15 µm or less, 12 µm or less, or 10 µm or less, as a specific example, 2 µm to 15 µm.

The expansion-inducing component may comprise one selected from the group consisting of a hydrocarbon compound, a tetraalkylsilane compound, and combinations thereof. Specifically, the hydrocarbon may comprise one selected from the group consisting of ethane, ethylene, propane, propene, n-butane, isobutane, n-butene, isobutene, n-pentane, isopentane, neopentane, n-hexane, heptane, petroleum ether, and combinations thereof. The tetraalkylsilane compound may comprise one selected from the group consisting of tetramethylsilane, trimethylethylsilane, trimethylisopropylsilane, trimethyl-n-propylsilane, and combinations thereof.

The solid phase foaming agent may comprise particles treated with an inorganic component. In an embodiment, the solid phase foaming agent may be one treated with silica (SiO₂) particles. The treatment of the solid phase foaming agent with an inorganic component can prevent aggregation between a plurality of particles. The solid phase foaming agent treated with an inorganic component may be different from the solid phase foaming agent that is not treated with an inorganic component in terms of the chemical, electrical, and/or physical properties of the surface of the foaming agent.

The commercial products of the solid phase foaming agent include Nouryon's 920DE20d70, 051DET40d25, and 051DET40d42 and Matsumoto's F-65DE, F-80DE, and FN-80SDE.

As a specific example, the foaming agent used in the polishing pad according to an embodiment comprises a solid phase foaming agent. The solid phase foaming agent may comprise at least one selected from the group consisting of an acrylonitrile-based copolymer, a methylmethacrylate-based copolymer, a methacrylonitrile-based copolymer, and an acrylic-based copolymer.

The content of the solid phase foaming agent may be 0.1 part by weight or more, 0.5 part by weight or more, or 1 part by weight or more, and 5 parts by weight or less, 3 parts by weight or less, or 2 parts by weight or less, relative to 100 parts by weight of the urethane-based prepolymer. As a specific example, the content of the solid phase foaming agent may be 0.1 part by weight to 5 parts by weight or 0.5 part by weight to 2 parts by weight, relative to 100 parts by weight of the urethane-based prepolymer.

The type and content of the solid phase foaming agent may be designed according to the desired pore structure and physical properties of the polishing layer.

Meanwhile, the liquid phase foaming agent may be introduced during the mixing and reaction of the prepolymer and the curing agent to form pores. It does not participate in the reaction between the prepolymer and the curing agent. In addition, the liquid phase foaming agent is physically vaporized by heat generated during the mixing and reaction of the prepolymer and the curing agent to form pores.

The volatile liquid phase foaming agent may be liquid at 25°C while it does not react with an isocyanate group, an amide group, and an alcohol group. Specifically, the volatile liquid phase foaming agent may be selected from the group consisting of cyclopentane, n-pentane, cyclohexane, n-butyl acetate, bis(nonafluorobutyl)(trifluoromethyl)amine; and perfluoro compounds such as perfluorotributylamine, perfluoro-N-methylmorpholine, perfluorotripentylamine, and perfluorohexane. Commercially available products of the perfluoro compound include FC-40 (3M), FC-43 (3M), FC-70 (3M), FC-72 (3M), FC-770 (3M), FC-3283 (3M), and FC-3284 (3M).

In addition, the foaming agent may comprise a gas phase foaming agent. For example, the foaming agent may comprise a solid phase foaming agent and a gas phase foaming agent.

The gas phase foaming agent may comprise an inert gas. The gas phase foaming agent is fed while the urethane-based prepolymer and the curing agent are reacted in order to be used as a component to form pores.

The kind of the inert gas is not particularly limited as long as it is a gas that does not participate in the reaction between the urethane-based prepolymer and the curing agent. For example, the inert gas may comprise one selected from the group consisting of nitrogen gas (N₂), carbon dioxide gas (CO₂), argon gas (Ar), helium gas (He), and combinations thereof.

The type and content of the gas phase foaming agent may be designed according to the desired pore structure and physical properties of the polishing layer.

The inert gas may be fed in a volume of 10% to 30% based on the total volume of the composition. Specifically, the inert gas may be fed in a volume of 15% to 30% based on the total volume of the composition. Specifically, the gas phase foaming agent may be fed through a predetermined feeding line while the urethane-based prepolymer, the solid phase foaming agent, and the curing agent are mixed. The feeding rate of the gas phase foaming agent is about 0.8 L/minute to about 2.0 L/ minute, for example, about 0.8 L/ minute to about 1.8 L/ minute, for example, about 0.8 L/ minute to about 1.7 L/ minute, for example, about 1.0 L/ minute to about 2.0 L/ minute, for example, about 1.0 L/ minute to about 1.8 L/ minute, for example, about 1.0 L/ minute to about 1.7 L/ minute.

### Curing agent

The curing agent is a compound for chemically reacting with the urethane-based prepolymer to form a final cured structure in the polishing layer. For example, it may comprise an amine compound or an alcohol compound. Specifically, the curing agent may comprise one selected from the group consisting of an aromatic amine, an aliphatic amine, an aromatic alcohol, an aliphatic alcohol, and combinations thereof.

According to an embodiment, the curing agent may comprise a non-chlorine-based curing agent that does not contain a chlorine component. For example, the content of the non-chlorine-based curing agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the curing agent. In addition, the content of the chlorine-based curing agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the curing agent.

The curing agent may be at least one selected from a solid phase curing agent and a liquid phase curing agent.

The solid phase curing agent may contain an active hydrogen group. The solid phase curing agent may contain an amine group (-NH₂) as an active hydrogen group.

In addition, the solid phase curing agent may be an ester compound containing two or more benzene rings. Specifically, the solid phase curing agent may comprise two or more of the ester groups in the molecule.

The solid phase curing agent may have a weight average molecular weight of 150 to 400, for example, 150 to 350, for example, 200 to 350, for example, 250 to 350, for example, 300 to 350. The solid phase curing agent may have a melting point (m.p.) of 100°C to 150°C, for example, 100°C to 140°C, for example, 110°C to 130°C.

In an embodiment, the solid phase curing agent comprises at least one selected from the group consisting of 1,3-propanediol bis(4-aminobenzoate) (PDPAB), 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The liquid phase curing agent may contain an active hydrogen group. The liquid phase curing agent may contain at least one selected from the group consisting of an amine group (-NH₂), a hydroxyl group (-OH), a carboxylic acid group (-COOH), an epoxy group, and combinations thereof as an active hydrogen group. Specifically, it may contain an amine group (-NH₂).

In addition, the liquid phase curing agent may contain sulfur in the molecule. Specifically, it may contain two or more sulfur elements in the molecule.

The liquid phase curing agent may have a weight average molecular weight of 50 to 300, for example, 100 to 250, for example, 150 to 250, for example, 200 to 250.

In addition, the liquid phase curing agent may be liquid at room temperature. Alternatively, the liquid phase curing agent may have a boiling point (b.p.) of 160°C to 240°C, specifically 170°C to 240°C, more specifically 170°C to 220°C.

Examples of the liquid phase curing agent include at least one selected from the group consisting of 3,5-dimethylthio-2,6-diaminotoluene (DMTDA), 2,6-bis(methylthio)-4-methyl-1,3-benzenediamine, and N,N'-bis(sec-butylamino)diphenylmethane.

In addition, the curing agents may further comprise other curing agents in addition to the liquid phase curing agent and the solid phase curing agent. The additional curing agent may be, for example, at least one of an amine compound and an alcohol compound. Specifically, the additional curing agent may comprise at least one compound selected from the group consisting of an aromatic amine, an aliphatic amine, an aromatic alcohol, and an aliphatic alcohol.

For example, the additional curing agent may be at least one selected from the group consisting of diaminodiphenylmethane, diaminodiphenyl sulphone, m-xylylene diamine, isophoronediamine, ethylenediamine, diethylenetriamine, triethylenetetramine, polypropylenediamine, polypropylenetriamine, ethylene glycol, diethylene glycol, dipropylene glycol, butanediol, hexanediol, glycerin, and trimethylolpropane.

As a specific example, the curing agent may comprise at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The content of the curing agent may be 5 parts by weight or more, 10 parts by weight or more, 15 parts by weight or more, or 20 parts by weight or more, and 50 parts by weight or less, 45 parts by weight or less, 40 parts by weight or less, 35 parts by weight or less, 30 parts by weight or less, or 25 parts by weight or less, relative to 100 parts by weight of the urethane-based prepolymer. The content of the curing agent may be 10 parts by weight to 40 parts by weight, more specifically, 15 parts by weight to 35 parts by weight or 15 parts by weight to 25 parts by weight, relative to 100 parts by weight of the urethane-based prepolymer.

### Additives

The composition for preparing a polishing layer may further comprise other additives such as a surfactant and a reaction rate controlling agent. The names such as "surfactant" and "reaction rate controlling agent" are arbitrary names based on the main role of the substances. The respective substances do not necessarily perform only a function limited to the role defined by the names.

The surfactant is not particularly limited as long as it acts to prevent pores from coalescing and overlapping with each other. For example, the surfactant may comprise a silicone-based surfactant.

The surfactant may be employed in an amount of 0.2 part by weight to 2 parts by weight relative to 100 parts by weight of the urethane-based prepolymer. Specifically, the surfactant may be employed in an amount of 0.2 part by weight to 1.9 parts by weight, for example, 0.2 part by weight to 1.8 parts by weight, for example, 0.2 part by weight to 1.7 parts by weight, for example, 0.2 part by weight to 1.6 parts by weight, for example, 0.2 part by weight to 1.5 parts, for example, 0.5 part by weight to 1.5 parts by weight, relative to 100 parts by weight of the urethane-based prepolymer. If the amount of the surfactant is within the above range, pores derived from the gas phase foaming agent can be stably formed and maintained in the mold.

The reaction rate controlling agent serves to promote or retard the reaction. A reaction promoter, a reaction retarder, or both may be used depending on the purpose. The reaction rate controlling agent may comprise a reaction promoter. For example, the reaction rate controlling agent may be at least one reaction promoter selected from the group consisting of a tertiary amine-based compound and an organometallic compound.

Specifically, the reaction rate controlling agent may comprise at least one selected from the group consisting of triethylenediamine, dimethylethanolamine, tetramethylbutanediamine, 2-methyl-triethylenediamine, dimethylcyclohexylamine, triethylamine, triisopropanolamine, 1,4-diazabicyclo(2,2,2)octane, bis(2-methylaminoethyl) ether, trimethylaminoethylethanolamine, N,N,N,N,N"-pentamethyldiethylenetriamine, dimethylaminoethylamine, dimethylaminopropylamine, benzyldimethylamine, N-ethylmorpholine, N,N-dimethylaminoethylmorpholine, N,N-dimethylcyclohexylamine, 2-methyl-2-azanorbornane, dibutyltin dilaurate, stannous octoate, dibutyltin diacetate, dioctyltin diacetate, dibutyltin maleate, dibutyltin di-2-ethylhexanoate, and dibutyltin dimercaptide. Specifically, the reaction rate controlling agent may comprise at least one selected from the group consisting of benzyldimethylamine, N,N-dimethylcyclohexylamine, and triethylamine.

The reaction rate controlling agent may be employed in an amount of 0.05 part by weight to 2 parts by weight relative to 100 parts by weight of the urethane-based prepolymer. Specifically, the reaction rate controlling agent may be employed in an amount of 0.05 part by weight to 1.8 parts by weight, for example, 0.05 part by weight to 1.7 parts by weight, for example, 0.05 part by weight to 1.6 parts by weight, for example, 0.1 part by weight to 1.5 parts by weight, for example, 0.1 part by weight to 0.3 part by weight, for example, 0.2 part by weight to 1.8 parts by weight, for example, 0.2 part by weight to 1.7 parts by weight, for example, 0.2 part by weight to 1.6 parts by weight, for example, 0.2 part by weight to 1.5 parts by weight, for example, 0.5 part by weight to 1 part by weight, relative to 100 parts by weight of the urethane-based prepolymer. If the reaction rate controlling agent is used in the above content range, the curing reaction rate of the prepolymer composition may be appropriately controlled to form a polishing layer having pores of a desired size and hardness.

### Support layer

The support layer constitutes a sub pad and serves to support the polishing layer and to absorb and disperse an impact applied to the polishing layer. Thus, it minimizes damage and defects to the object to be polished during the polishing process using the polishing pad.

The support layer may comprise a nonwoven fabric or a suede, but it is not limited thereto.

In an embodiment, the support layer may be a resin-impregnated nonwoven fabric. The nonwoven fabric may be a fibrous nonwoven fabric comprising one selected from the group consisting of a polyester fiber, a polyamide fiber, a polypropylene fiber, a polyethylene fiber, and combinations thereof.

The resin impregnated in the nonwoven fabric may comprise a polyurethane resin, a polybutadiene resin, a styrene-butadiene copolymer resin, a styrene-butadiene-styrene copolymer resin, an acrylonitrile-butadiene copolymer resin, a styrene-ethylene-butadiene-styrene copolymer resin, a silicone rubber resin, a polyester-based elastomer resin, a polyamide-based elastomer resin, and combinations thereof.

The support layer may have a thickness of, for example, 0.3 mm or more or 0.5 mm or more, and 3 mm or less, 2 mm or less, or 1 mm or less. As a specific example, the thickness of the support layer may be 0.3 mm to 3 mm or 0.5 mm to 1 mm.

The support layer may have a hardness of, for example, 50 Asker C or more, 60 Asker C or more, or 70 Asker C or more, and 100 Asker C or less, 90 Asker C or less, or 80 Asker C or less. As a specific example, the hardness of the support layer may be 50 Asker C to 100 Asker C or 60 Asker C to 90 Asker C.

In addition, an adhesive layer may be interposed between the polishing layer (top pad) and the support layer (sub pad).

The adhesive layer may comprise a hot melt adhesive. The hot melt adhesive may be at least one selected from the group consisting of a polyurethane resin, a polyester resin, an ethylene-vinyl acetate resin, a polyamide resin, and a polyolefin resin. Specifically, the hot melt adhesive may be at least one selected from the group consisting of a polyurethane resin and a polyester resin.

In addition, a double-sided adhesive tape may be laminated under the support layer. When it is applied to CMP equipment, it is attached to the platen for use once the release paper of the double-sided adhesive tape has been removed.

### Process for preparing a polishing pad

The process for preparing a polishing pad (e.g. as above, below or in the claims) according to an embodiment comprises preparing a composition for a polishing pad comprising a urethane-based prepolymer, a foaming agent, and a curing agent; injecting the composition for a polishing pad into a mold and curing it to prepare a polishing layer; and laminating the polishing layer with a support layer.

The specific types and contents of the urethane-based prepolymer, curing agent, and foaming agent are as exemplified above.

As a specific example, the foaming agent comprises a solid phase foaming agent, the solid phase foaming agent comprises at least one selected from the group consisting of an acrylonitrile-based copolymer, a methyl methacrylate-based copolymer, a methacrylonitrile-based copolymer, and an acrylic-based copolymer, and the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The composition for a polishing pad may be prepared by sequentially or simultaneously mixing a urethane-based prepolymer, a foaming agent, and a curing agent.

As an example, the step of preparing the composition for a polishing pad may be carried out by mixing a urethane-based prepolymer with a curing agent, followed by further mixing with a foaming agent, or by mixing the urethane-based prepolymer with the foaming agent, followed by further mixing with the curing agent.

As another example, a urethane-based prepolymer, a curing agent, and a foaming agent may be put into the mixing process substantially at the same time. If a foaming agent, a surfactant, and an inert gas are further added, they may be put into the mixing process substantially at the same time.

As another example, a urethane-based prepolymer, a foaming agent, and a surfactant may be mixed in advance, and a curing agent, or a curing agent with an inert gas, may be subsequently introduced.

The mixing initiates the reaction of the urethane-based prepolymer and the curing agents and uniformly disperses the foaming agent and the inert gas in the raw materials. In such an event, a reaction rate controlling agent may intervene in the reaction between the urethane-based prepolymer and the curing agent from the beginning of the reaction, to thereby control the reaction rate. Specifically, the mixing may be carried out at a speed of 1,000 to 10,000 rpm or 4,000 to 7,000 rpm. Within the above speed range, it may be more advantageous for the inert gas and the foaming agent to be uniformly dispersed in the raw materials.

In addition, the step of preparing the composition for a polishing pad may be carried out under the condition of 50°C to 150°C. If necessary, it may be carried out under vacuum defoaming conditions.

If the foaming agent comprises a solid phase foaming agent, the step of preparing the composition for a polishing pad may comprise mixing the urethane-based prepolymer and the solid phase foaming agent to prepare a first preliminary composition; and mixing the first preliminary composition and the curing agent to prepare a second preliminary composition.

The first preliminary composition may have a viscosity of about 1,000 cps to about 2,000 cps, for example, about 1,000 cps to about 1,800 cps, for example, about 1,000 cps to about 1,600 cps, for example, about 1,000 cps to about 1,500 cps at about 80°C.

If the foaming agent comprises a gas phase foaming agent, the step of preparing the composition for a polishing pad may comprise preparing a third preliminary composition comprising the urethane-based prepolymer and the curing agent; and feeding the gas phase foaming agent to the third preliminary composition to prepare a fourth preliminary composition. In an embodiment, the third preliminary composition may further comprise a solid phase foaming agent.

In an embodiment, the step of preparing a polishing layer comprises preparing a mold preheated to a first temperature; and injecting the composition for a polishing pad into the preheated mold and curing it; and post-curing the cured composition for a polishing pad under a second temperature condition higher than the preheating temperature.

In an embodiment, the temperature difference between the first temperature and the second temperature may be about 10°C to about 40°C, for example, about 10°C to about 35°C, for example, about 15°C to about 35°C. In an embodiment, the first temperature may be about 60°C to about 100°C, for example, about 65°C to about 95°C, for example, about 70°C to about 90°C. In an embodiment, the second temperature may be about 100°C to about 130°C, for example, about 100°C to 125°C, for example, about 100°C to about 120°C.

The step of curing the composition for a polishing pad at the first temperature may be carried out for about 5 minutes to about 60 minutes, for example, about 5 minutes to about 40 minutes, for example, about 5 minutes to about 30 minutes, for example, about 5 minutes to about 25 minutes.

The step of post-curing the composition for a polishing pad cured at the first temperature at the second temperature may be carried out for about 5 hours to about 30 hours, for example, about 5 hours to about 25 hours, for example, about 10 hours to about 30 hours, for example, about 10 hours to about 25 hours, for example, about 12 hours to about 24 hours, for example, about 15 hours to about 24 hours.

Thereafter, the step of injecting the composition for a polishing pad into a mold and curing it may be carried out under the temperature condition of 60°C to 120°C and the pressure condition of 50 kg/m² to 200 kg/m².

In addition, the above preparation process may further comprise the steps of cutting the surface of a polishing pad thus obtained, machining grooves on the surface thereof, bonding it with a lower part, inspection, packaging, and the like. These steps may be carried out in a conventional manner for preparing a polishing pad.

As an example, the process for preparing a polishing pad may further comprise machining at least one side of the polishing layer. The step of machining at least one side of the polishing layer may comprise forming grooves on at least one side of the polishing layer; lathe turning at least one side of the polishing layer; and roughening at least one side of the polishing layer.

The grooves may comprise at least one of concentric circular grooves spaced apart from the center of the polishing layer at a certain interval; and radial grooves continuously connected from the center of the polishing layer to the edge of the polishing layer. The lathe turning may be carried out by cutting the polishing layer in a certain thickness using a cutting tool. The roughening may be carried out by machining the surface of the polishing layer with a sanding roller.

### Process for preparing a semiconductor device

The process for preparing a semiconductor device according to an embodiment comprises polishing the surface of a semiconductor substrate using the polishing pad according to an embodiment.

Specifically, the process for preparing a semiconductor device may comprise providing the polishing pad according to an embodiment; and relatively rotating the polishing surface of the polishing layer and the surface of a semiconductor substrate while they are in contact with each other to polish the surface of the semiconductor substrate.

Fig. 1 illustrates a process for preparing a semiconductor device using a polishing pad according to an embodiment. Referring to Fig. 1, once the polishing pad (100) according to an embodiment has been attached to a platen (200), a semiconductor substrate (600) as an object to be polished is disposed on the polishing pad (100). In such an event, the surface of the semiconductor substrate (600) to be polished is in direct contact with the polishing surface of the polishing pad (100). A polishing slurry (400) may be sprayed through a nozzle onto the polishing pad for polishing. The flow rate of the polishing slurry (400) supplied through the nozzle may be selected according to the purpose within a range of about 10 cm³/minute to about 1,000 cm³/minute. For example, it may be about 50 cm³/minute to about 500 cm³/minute, but it is not limited thereto.

Thereafter, the semiconductor substrate (600) and the polishing pad (100) rotate relatively to each other, so that the surface of the semiconductor substrate (600) is polished. In such an event, the rotation direction of the semiconductor substrate (600) and the rotation direction of the polishing pad (100) may be the same direction or opposite directions. The rotation speeds of the semiconductor substrate (600) and the polishing pad (100) may each be selected according to the purpose within a range of about 10 rpm to about 500 rpm. For example, it may be about 30 rpm to about 200 rpm, but it is not limited thereto.

The semiconductor substrate (600) mounted on the polishing head (510) is pressed against the polishing surface of the polishing pad (100) at a predetermined load to be in contact therewith, and the surface thereof may then be polished. The load applied to the polishing surface of the polishing pad (100) through the surface of the semiconductor substrate (600) by the polishing head (510) may be selected according to the purpose within a range of about 1 gf/cm² to about 1,000 gf/cm². For example, it may be about 10 gf/cm² to about 800 gf/cm², but it is not limited thereto.

In an embodiment, the semiconductor substrate (600) as an object to be polished may comprise an oxide layer, a tungsten layer, or a composite layer thereof. Specifically, the semiconductor substrate (600) may comprise an oxide layer, a tungsten layer, or a composite layer of an oxide layer and a tungsten layer. The composite layer of an oxide layer and a tungsten layer may be a multilayer film in which the tungsten layer is laminated on one side of the oxide layer or may be a single-layer film in which an oxide region and a tungsten region are mixed in a single layer. As the object to be polished has such a film substance, and, at the same time, the polishing pad has characteristics according to the embodiment, a semiconductor device fabricated according to the process for preparing a semiconductor device may have minimum defects.

In an embodiment, the process for preparing a semiconductor device may further comprise, in the step of polishing the object to be polished, supplying any one of a slurry for polishing an oxide layer and a slurry for polishing a tungsten layer; or sequentially supplying the slurry for polishing an oxide layer and the slurry for polishing a tungsten layer to the polishing surface.

For example, if the semiconductor substrate as an object to be polished comprises an oxide layer, the process for preparing a semiconductor device may comprise supplying a slurry for polishing an oxide layer. If the semiconductor substrate comprises a tungsten layer, the process for preparing a semiconductor device may comprise supplying a slurry for polishing a tungsten layer. If the semiconductor substrate comprises a composite layer of an oxide layer and a tungsten layer, the process for preparing a semiconductor device may comprise sequentially supplying a slurry for polishing an oxide layer and a slurry for polishing a tungsten layer to the polishing surface. Here, depending on the process, the slurry for polishing an oxide layer may be supplied first and then the slurry for polishing a tungsten layer may be supplied later, or the slurry for polishing a tungsten layer may be supplied first and then the slurry for polishing an oxide layer may be supplied later.

In an embodiment, in order to maintain the polishing surface of the polishing pad (100) in a state suitable for polishing, the process for preparing a semiconductor device may further comprise processing the polishing surface of the polishing pad (100) with a conditioner (300) simultaneously with polishing the semiconductor substrate (600).

As the polishing pad according to an embodiment has a content of chlorine in the polishing layer adjusted to a certain range, it is possible to reduce the size of debris while maintaining excellent physical properties and performance of the polishing pad, thereby minimizing the occurrence of defects and scratches during a CMP process. Thus, it is possible to efficiently prepare a semiconductor device with high quality using the polishing pad.

### Mode for the Invention

Although the following examples are described, the scope of possible implementations is not limited thereto.

### Examples and Comparative Example: Preparation of a polishing pad

### Step (1) Preparation of a prepolymer

A four-necked flask was charged with toluene diisocyanate (TDI), dicyclohexylmethane diisocyanate (H12MDI), polytetramethylene ether glycol (PTMEG), and diethylene glycol (DEG), followed by reaction thereof at 80°C for 3 hours, thereby preparing a urethane-based prepolymer. The NCO% of the prepolymer was measured and is shown in Table 1 below.

### Step (2) Preparation of a polishing pad

A casting machine equipped with tanks and feeding lines for the raw materials such as a prepolymer, a curing agent, an inert gas, and a foaming agent was provided. The urethane-based prepolymer prepared above, a foaming agent, a curing agent, an inert gas (N₂), and a silicone-based surfactant (Evonik) were each charged to the tanks. The raw materials were stirred while they were fed to the mixing head at constant rates through the respective feeding lines. The foaming agent and the curing agent listed in Table 1 below were used. The prepolymer and the curing agent were fed at an equivalent ratio of 1:1 and at a total rate of 10 kg/minute.

A mold (1,000 mm × 1,000 mm × 3 mm) was prepared and preheated at a temperature of 80°C. The mixed raw materials prepared above were injected into the mold and reacted to obtain a molded article in the form of a solid cake. Thereafter, the top and bottom of the molded article were each ground to obtain a polishing layer for a top pad.

Thereafter, the polishing layer was subjected to surface milling and groove-forming steps and laminated with a support layer for a sub pad by a hot melt adhesive, thereby preparing a polishing pad.

A double-sided adhesive tape (442JS, 3M) was laminated under the support layer so that it could be attached to the platen of CMP equipment.

The curing agent and the foaming agent used in the Examples and Comparative Examples are as follows.
- DMTDA: 3,5-dimethylthio-2,6-diaminotoluene, Covestro
- MOCA: 4,4'-methylene bis(2-chloroaniline), Ishihara
- F-65DE: acrylonitrile/methyl methacrylate/methacrylonitrile copolymer, expanded cell type, Matsumoto
- F-80DE: acrylonitrile/methyl methacrylate/methacrylonitrile copolymer, expanded cell type, Matsumoto
- 051DET40d25: acrylonitrile/methacrylonitrile copolymer, expanded cell type, Noury on
- 051DET40d42: acrylonitrile/methacrylonitrile copolymer, expanded cell type, Nouryon
- 461DET40d25: acrylonitrile/dichloroethane, expanded cell type, Nouryon

Details of the Examples and Comparative Examples are summarized in Table 1 below.

**[Table 1]**

| | | | Ex. 1 | Ex. 2 | Ex. 3 | Ex. 4 | Ex. 5 | Ex. 6 | Ex. 7 | C. Ex. 1 | C. Ex. 2 |
|---|---|---|---|---|---|---|---|---|---|---|---|
| Polishing layer | Prepolymer NCO% | | 10% | 10% | 10% | 10% | 10% | 10% | 10% | 10% | 10% |
| | Curing | DMTDA | 100 | 100 | 100 | 99 | 96 | 90 | 86 | - | - |
| | agent (weight ratio) | MOCA | - | - | - | 1 | 4 | 10 | 14 | 100 | 100 |
| | Solid phase foaming agent | | F-65DE | 051DET 40d25 | F-80DE | F-50D | 051DET 40d25 | F-80DE | F-50D | 051DET 40d42 | 461DET 40d25 |
| | Casting mold | | Single layer | Single layer | Single layer | Single layer | Single layer | Single layer | Single layer | Single layer | Single layer |
| | Casting, cutting, & grooving* | | Seq. | Seq. | Seq. | Seq. | Seq. | Seq. | Seq. | Seq. | Seq. |
| | Prepolymer (part by weight) | | 100 | 100 | 100 | 100 | 100 | 100 | 100 | 100 | 100 |
| | Curing agent (part by weight) | | 32 | 32 | 32 | 32 | 32 | 32 | 32 | 32 | 32 |
| | Surfactant (part by weight) | | 1.0 | 1.0 | 1.0 | 1 | 1 | 1 | 1 | 1.0 | 1.0 |
| | Solid phase foaming agent (part by weight) | | 1.0 | 1.0 | 1.0 | 1 | 1 | 1 | 1 | 1.0 | 1.0 |
| | Inert gas (l/min) | | 1.5 | 1.5 | 1.5 | 1.5 | 1.5 | 1.5 | 1.5 | 1.5 | 1.5 |

| | | | | | | | | | | | |
|---|---|---|---|---|---|---|---|---|---|---|---|
| * Seq.: sequential | | | | | | | | | | | |

### Test Example 1:

The polishing layers, support layers, and polishing pads in which they had been laminated as prepared above were each tested as follows.

### (1) Hardness

Each sample was cut to 5 cm × 5 cm (thickness: 2 mm) and stored at room temperature and a temperature of 30°C, 50°C, and 70°C, respectively, for 12 hours to measure the Shore D hardness and Asker C hardness using a hardness tester.

### (2) Specific gravity

Each sample was cut to 2 cm × 5 cm (thickness: 2 mm) and stored at a temperature of 25°C for 12 hours to measure the specific gravity using a gravimeter.

### (3) Tensile strength

Each sample was cut to 4 cm × 1 cm (thickness: 2 mm). The ultimate strength immediately before the fracture was measured while the sample was tested at a rate of 50 mm/minute using a universal testing machine (UTM).

### (4) Elongation

Each sample was cut to 4 cm × 1 cm (thickness: 2 mm). The maximum deformation immediately before the fracture was measured while the sample was tested at a rate of 50 mm/minute using a universal testing machine (UTM). The ratio of the maximum deformation to the initial length was expressed in percent (%).

The results are shown in the tables below.

**[Table 2]**

| | | Ex. 1 | Ex. 2 | Ex. 3 | Ex. 4 | Ex. 5 | Ex. 6 | Ex. 7 | C. Ex. 1 | C. Ex. 2 |
|---|---|---|---|---|---|---|---|---|---|---|
| Polishing layer | Thickness (mm) | 2 | 2 | 2 | 2 | 2 | 2 | 2 | 2 | 2 |
| | Hardness (Shore D) | 58.8 | 59.2 | 59.1 | 58.6 | 59.4 | 59.2 | 58.5 | 58.9 | 59.3 |
| | Specific gravity (g/cc) | 0.79 | 0.79 | 0.79 | 0.79 | 0.79 | 0.79 | 0.79 | 0.79 | 0.79 |
| | Tensile strength (N/mm²) | 20.9 | 20.8 | 20.4 | 21 | 20.7 | 21.2 | 20.4 | 20.5 | 20.6 |
| | Elongation (%) | 111 | 108 | 109 | 105 | 101 | 103 | 102 | 101 | 109 |
| Support layer | Type* | NW fabric | NW fabric | NW fabric | NW fabric | NW fabric | NW fabric | NW fabric | NW fabric | NW fabric |
| | Thickness (mm) | 1.1 | 1.1 | 1.1 | 1.1 | 1.1 | 1.1 | 1.1 | 1.1 | 1.1 |
| | Hardness (Asker C) | 70 | 70 | 70 | 70 | 70 | 70 | 70 | 70 | 70 |
| Laminated pad | Thickness (mm) | 3.32 | 3.32 | 3.32 | 3.32 | 3.32 | 3.32 | 3.32 | 3.32 | 3.32 |
| | Compressibility (%) | 1.05 | 1.05 | 1.05 | 1.05 | 1.05 | 1.05 | 1.05 | 1.05 | 1.05 |

| | | | | | | | | | | |
|---|---|---|---|---|---|---|---|---|---|---|
| * NW fabric: nonwoven fabric | | | | | | | | | | |

As shown in the table above, the polishing pads of Examples 1 to 7 were at least equal to the polishing pads of Comparative Examples 1 and 2 in terms of hardness, specific gravity, tensile strength, and elongation.

### Test Example 2

The polishing pads prepared above were each tested as follows.

### (1) Polishing rate (removal rate)

A silicon wafer having a diameter of 300 mm on which silicon oxide had been deposited by a CVD process was set on the porous polyurethane polishing pad mounted on the platen in a CMP polishing machine, while the silicon oxide layer of the silicon wafer faced downward.

Then, the silicon oxide layer was polished under a polishing load of 4.0 psi while the polishing pad was rotated at a speed of 150 rpm, a calcined ceria slurry was supplied onto the polishing pad at a rate of 250 ml/minute, and the platen was rotated at a speed of 150 rpm for 60 seconds.

Upon completion of the polishing, the silicon wafer was detached from the carrier, mounted in a spin dryer, washed with deionized water (DIW), and then dried with nitrogen for 15 seconds. The film thickness of the dried silicon wafer was measured before and after the polishing using a spectral reflectometer-type thickness measuring instrument (manufacturer: Keyence, model: SI-F80R).

The polishing rate was calculated using the following Equation 1. Polishing rate (Å/minute) = polished thickness of a silicon wafer (Å) / polishing time (minute)

### (2) Defects

Polishing was carried out in the same manner as the polishing rate test using a CMP polishing machine. Upon completion of the polishing, the silicon wafer was transferred to a cleaner and cleaned for 10 seconds each using 1% HF, deionized water (DIW), 1% H₂NO₃, and deionized water (DIW). Thereafter, it was transferred to a spin dryer, washed with deionized water (DIW), and then dried with nitrogen for 15 seconds. The change in defects of the dried silicon wafer before and after the polishing was measured using a defect measurement device (manufacturer: Tenkor, model: XP+). Specifically, the total number of scratches, chatter marks, pits, and residues on the surface of the wafer was measured.

### (3) Chlorine content

A circular sample having a size of 3 cm in diameter and 0.3 cm in height was prepared from the polishing layer of the polishing pad. The content of chlorine in the sample was measured by IEC 62321-3-2, which is an international standard for measuring specific substances in a polymer by combustion-ion chromatography (C-IC) (see Fig. 3).

### (4) Debris size

A porous polyurethane polishing pad was attached to the platen of a CMP polishing machine. Thereafter, excluding the operation of the carrier, the debris of the polishing layer was collected using only the conditioner and deionized water (DIW). Conditioning of the polishing layer was carried out while deionized water was supplied at 300 cc/minute under the conditions of a platen speed of 93 rpm, a conditioner load of 9 lbs., a rotation speed of 64 rpm, and a sweep speed of 19 times/minute. Debris from the polishing layer along with deionized water was collected during conditioning. The D50 particle size of the collected debris was measured using a particle size analyzer (Mastersize 3000, Malvern) and a medium-capacity automatic disperser (Hydro MV, Malvern). The analyzer was set with a polyurethane of 1.55 as the refractive index of a material to be analyzed, deionized water of 1.33 as the refractive index of a dispersant, and a stirring speed of 2,500 rpm.

### (5) Zeta potential

A porous polyurethane polishing pad was attached to the platen of a CMP polishing machine. Thereafter, excluding the operation of the carrier, the debris of the polishing layer was collected using only the conditioner and deionized water (DIW).

Conditioning of the polishing layer was carried out for a disc of CI45 while deionized water was supplied at 300 cc/minute under the conditions of a platen speed of 93 rpm, a conditioner load of 9 lbs., a rotation speed of 64 rpm, and a sweep speed of 19 times/minute. The debris of the polishing layer formed during conditioning was collected in a solution state mixed with deionized water and stored for 24 hours. The supernatant located within 10 mm from the top surface of the solution was taken as a sample. The sample obtained had a pH of about 6.5, and the pH was adjusted to 5.5 using nitric acid and potassium hydroxide. Here, the concentration of the aqueous nitric acid solution used was 35%, and the concentration of the aqueous potassium hydroxide solution was 10%. In addition, the concentration of debris in the liquid sample was found to be about 0.01% by weight. The concentration was measured using a heated moisture meter (MX-50, AND) after placing about 5 g of a liquid sample in an aluminum dish.

The zeta potential of the sample was measured using a zetasizer (Nano-ZS90, Malvern). Specifically, 1 mL of the sample was charged to the cuvette of the zetasizer and measured three times to obtain the zeta potential. In such an event, the equipment setting value was set to RI 1.550 Absorption 0.010 based on the polyurethane value.

The test results are summarized in the following table.

**[Table 3]**

| | Ex. 1 | Ex. 2 | Ex. 3 | Ex. 4 | Ex. 5 | Ex. 6 | Ex. 7 | C. Ex. 1 | C. Ex. 2 |
|---|---|---|---|---|---|---|---|---|---|
| Cl content (ppm) | 36 | 32 | 33 | 500 | 2,000 | 5,000 | 7,000 | 28,614 | 54,786 |
| Polishing rate in a ceria slurry (Å/min) | 2,412 | 2,388 | 2,398 | 2,379 | 2,415 | 2,422 | 2,392 | 2,403 | 2,401 |
| Defects/scratches (EA) | 5 | 7 | 3 | 8 | 14 | 13 | 15 | 25 | 28 |
| Debris size (µm) | 17.1 | 16.8 | 16.5 | 18.1 | 19.2 | 19.6 | 21 | 25.2 | 27.3 |
| Zeta potential (mV, based on pH 5.5) | 9.2 | 12.5 | 8.1 | 6.2 | 3.2 | 1.3 | -4 | -23.1 | -24.7 |

As can be seen from the table above, the polishing pads of Examples 1 to 7 were measured with a chlorine (Cl) content within the desirable range, and the performance thereof such as polishing rate was equal to, or higher than, that of Comparative Examples 1 and 2. In particular, the debris size of the polishing pads of Examples 1 to 7 was measured to be smaller than that of Comparative Examples 1 and 2, and the number of defects and scratches was measured to be significantly lower. In addition, the zeta potential of the polishing pads of Examples 1 to 7 was measured to be within the desirable range.

## Claims

1. A polishing pad, which comprises a polishing layer and a support layer, wherein the polishing layer comprises a urethane-based prepolymer, a foaming agent, and a curing agent, and the polishing layer has a content of chlorine (Cl) of 10,000 ppm or less when analyzed according to the IEC 62321-3-2 standard.

2. The polishing pad of claim 1, wherein the polishing layer has a content of chlorine (Cl) of 10 ppm to 1,000 ppm when analyzed according to the IEC 62321-3-2 standard.

3. The polishing pad of claim 1 or claim 2, wherein the foaming agent comprises a solid phase foaming agent, and the solid phase foaming agent comprises at least one selected from the group consisting of an acrylonitrile-based copolymer, a methyl methacrylate-based copolymer, a methacrylonitrile-based copolymer, and an acrylic-based copolymer.

4. The polishing pad of any of claims 1 to 3, wherein the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

5. The polishing pad of any of claims 1 to 4, wherein the polishing layer has a hardness of 50 Shore D to 65 Shore D, a tensile strength of 15 N/mm² to 25 N/mm², and an elongation of 90% to 130%.

6. The polishing pad of any of claims 1 to 5, wherein the zeta potential value of an aqueous solution of a pH of 5.5 containing debris obtained by conditioning the polishing layer at a concentration of 0.01% by weight is -10 mV to 30 mV.

7. The polishing pad of any of claims 1 to 6, wherein, when the polishing pad is conditioned while deionized water is supplied at 300 cc/minute under the conditions of a platen speed of 93 rpm, a conditioner load of 9 lbs., a conditioner speed of 64 rpm, and a sweep of 19 times/minute, the D50 particle size of the polishing pad debris formed is 30 µm or less.

8. The polishing pad of any of claims 1 to 7, wherein, when the silicon oxide layer of a silicon wafer is polished with a ceria slurry using the polishing pad, the polishing rate according to the following Equation 1 is 2,200 Å/minute to 2,600 Å/minute: Polishing rate (Å/minute) = polished thickness of a silicon wafer (Å) / polishing time (minute)

9. A process for preparing a polishing pad, which comprises:
preparing a composition for a polishing pad comprising a urethane-based prepolymer, a foaming agent, and a curing agent;
injecting the composition for a polishing pad into a mold and curing it to prepare a polishing layer; and
laminating the polishing layer with a support layer,
wherein the foaming agent comprises a solid phase foaming agent, the solid phase foaming agent comprises at least one selected from the group consisting of an acrylonitrile-based copolymer, a methyl methacrylate-based copolymer, a methacrylonitrile-based copolymer, and an acrylic-based copolymer, and
the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

10. A process for preparing a semiconductor device, which comprises polishing the surface of a semiconductor substrate using the polishing pad of any of claims 1 to 8.
